Europäisches Patentamt

European Patent Office

Office européen des brevets

(19)

(11) Publication number: **0 067 677**
**B1**

(12) **EUROPEAN PATENT SPECIFICATION**

(45) Date of publication of patent specification: **09.09.87**

(21) Application number: **82303014.3**

(22) Date of filing: **10.06.82**

(51) Int. Cl.⁴: **H 01 L 23/04,** H 01 L 23/52,
H 01 L 23/12

(54) **Chip-array-constructed semiconductor device.**

(30) Priority: **15.06.81 JP 91799/81**

(43) Date of publication of application:
**22.12.82 Bulletin 82/51**

(45) Publication of the grant of the patent:
**09.09.87 Bulletin 87/37**

(84) Designated Contracting States:
**DE FR GB**

(56) References cited:
**FR-A-2 266 305**
**GB-A-2 056 772**
**US-A-3 611 317**

(73) Proprietor: **FUJITSU LIMITED**
**1015, Kamikodanaka Nakahara-ku**
**Kawasaki-shi Kanagawa 211 (JP)**

(72) Inventor: **Takemae, Yoshihiro**
**1-20-5-9-301 Utsukushigaoka Midori-ku**
**Yokohama-shi Kanagawa 227 (JP)**

(74) Representative: **Rackham, Stephen Neil et al**
**GILL JENNINGS & EVERY 53-64 Chancery Lane**
**London WC2A 1HN (GB)**

## Description

The present invention relates to a semiconductor device, particularly to a chip-array-constructed semiconductor device in which a plurality of semiconductor chips are mounted in a single package.

Usually, in semiconductor integrated circuit (IC) devices such as semiconductor logic devices or semiconductor memory devices, only one semiconductor IC chip is mounted in a package. On the other hand, as a computer system increases its performance and capacity, the number of packages on which electric components such as semiconductor IC chips are mounted increases, causing the computer system to be large in scale. In view of this, recently a plurality of semiconductor IC chips have been mounted in the same package and, accordingly, the packing density of the semiconductor IC chips has increased. Such a semiconductor package in which a plurality of semiconductor chips are mounted is called a chip-array-constructed semiconductor device.

In the chip-array-constructed semiconductor device however, in the past to avoid the intersection of bonding wires in the package, the chips have usually been mounted on a multilayer printed board which forms part of the package.

One previous proposal described in FR—A—2266305 discloses a chip-array-constructed semiconductor device comprising a plurality of semiconductor chips having circuit elements thereon and having connection pads, and a mounting of a generally rectangular shape on which the plurality of semiconductor chips are mounted, the mounting carrying a single conducting layer, the semiconductor chips having their connection pads arranged around their periphery with the connection pads that are common to all the chips arranged in corresponding positions along two opposite sides on all the chips, and the single conducting layer being divided into common conducting strips which are connected to the corresponding common connection pads, and into individual conducting strips which are connected to the connection pads that are individual to the individual chips.

According to this invention in such a chip-array-constructed semiconductor device the individual chips have their individual connection pads arranged along one or both ends of the chips, the common conducting strips extend lengthwise along the mounting under the chips and the individual connecting strips extend generally transverse to and at one or both sides of the common conducting strips to external leads located at the ends of the mounting.

A particular example of a chip-array-constructed semiconductor device in accordance with this invention will now be described with reference to the accompanying drawings; in which:—

Figure 1 is a plan of a single semiconductor chip showing the location of its connection pads;

Figures 2A, 2B and 2C are, respectively, a plan, a longitudinal section taken along the line B—B' and a cross-section taken along the line C—C', of a mounting for a plurality of chips;

Figures 3A, 3B, 3C are, respectively, a plan, a longitudinal section taken along the line C—C', of a partly completed device showing the plurality of chips connected to the mounting; and,

Figures 4A and 4B are, respectively, a longitudinal section and a cross-section through a completed packaged device.

A semiconductor chip 1 has circuit elements (not shown) such as memory cells and the like formed thereon. The cross-hatched portions 2—1 to 2—6 indicate common connection pads for receiving common signals such as common power supply voltages, common address signals, and the like while the hatched portion 3 indicates an individual connection pad for receiving an individual signal such as a clock signal, an input/output signal, or the like peculiar to this chip. Such connection pads are arranged along peripheral portions of the chip 1. For example, the pads 2—1 to 2—6 are arranged along the Y-axis while the pads 3 are arranged along the X-axis. Note that the connection pads 2—1 through 2—6 and 3 are formed by a single conductive layer such as aluminum (Al) or the like.

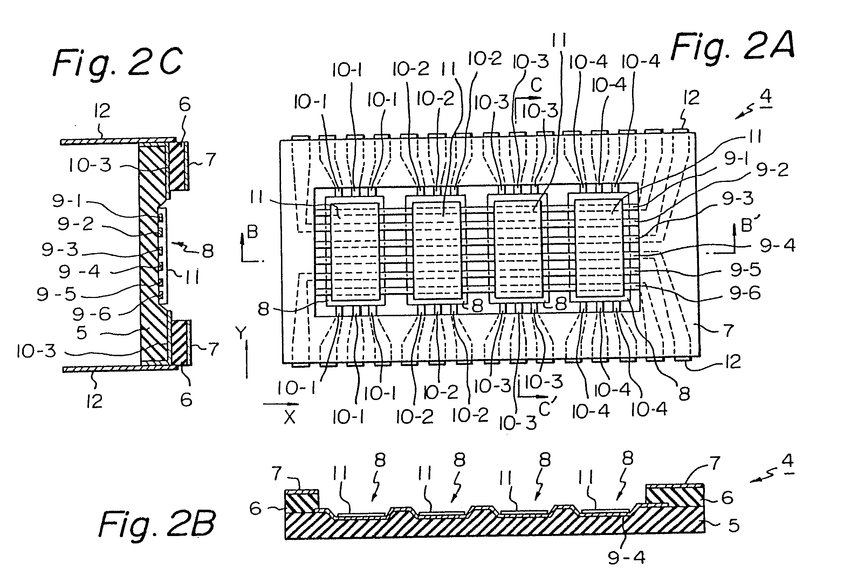

Figure 2A is a plan view illustrating an embodiment of the package according to the present invention, and Figs. 2B and 2C are cross-sectional views taken along the line B—B' and the line C—C', respectively, of Fig. 2A. Referring to Figs. 2A through 2C, a package 4 comprises a ceramic base 5, made of alumina or the like, to which a ceramic frame 6 having a metallized layer 7 for sealing thereon is bonded with glass (not shown). In addition, the ceramic base 5 has recess portions 8 for mounting semiconductor chips thereon.

On the ceramic base 5, including its recess portions 8, a plurality of common conductive strips 9—1 through 9—6 are arranged in parallel to the X-direction and extend to the end face on the longer side of the ceramic base 5. In addition, on the ceramic base 5, a plurality of individual conductive strips 10—1 through 10—4 are arranged on at least one side (in this case, on both sides) of the common conductive strips 9—1 through 9—6 in parallel to the Y-direction and extend to the end surface on the longer side of the ceramic base 5. Note that exposed portions of the conductive strips 9—1 through 9—6 and 10—1 through 10—4 at the edges of the recess portions 8 are called bonding posts.

Reference numeral 11 indicates a chip base bonded with glass (not shown) to each recess portion 8. The chip base 11 is formed from for example, a ceramic plate of alumina, beryllia, or the like. Reference numeral 12 indicates an external lead made of Kovar or the like which is bonded by soldering to one of the conductive strips 9—1 through 9—6 and 10—1 through 10—4.

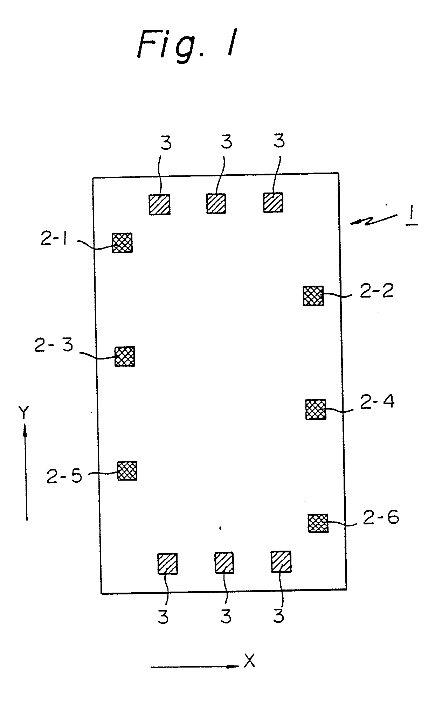

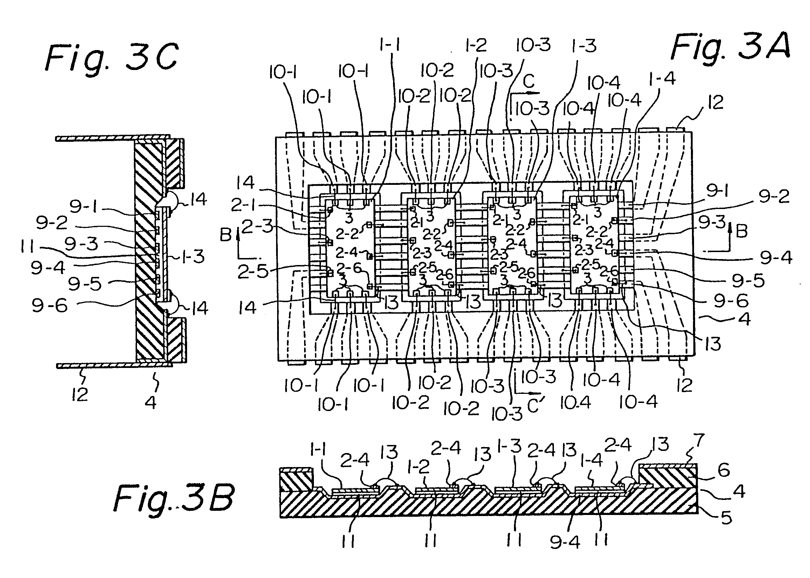

In Figs. 3A, 3B, and 3C, which are similar to Figs. 2A, 2B, and 2C, respectively, four semiconductor chips 1—1 through 1—4, which are the same as the chip 1 illustrated in Fig. 1, are mounted on the package as illustrated in Figs. 2A, 2B, and 2C. Each of the semiconductor chips 1—1 through 1—4 is fixed by depositing epoxy resin (not shown) on one of the chip bases 11 of the package 4.

The common conductive strips 9—1 through 9—6 are commonly used for the semiconductor chips 1—1 through 1—4 while the individual conductive strips 10—1, 10—2, 10—3, and 10—4 are peculiar to the semiconductor chips 1—1, 1—2, 1—3, and 1—4, respectively.

For example, the common connection pads 2—1 through 2—6 of the semiconductor chip 1—1 are electrically connected to the bonding post of one of the common conductive strips 9—1 through 9—6 by bonding wires 13 while the individual connection pads 3 of the semiconductor chip 1—1 are electrically connected to the individual conductive strips 10—1 by bonding wires 14. In this case, the wires 13 and 14 are made a aluminum, gold, or the like.

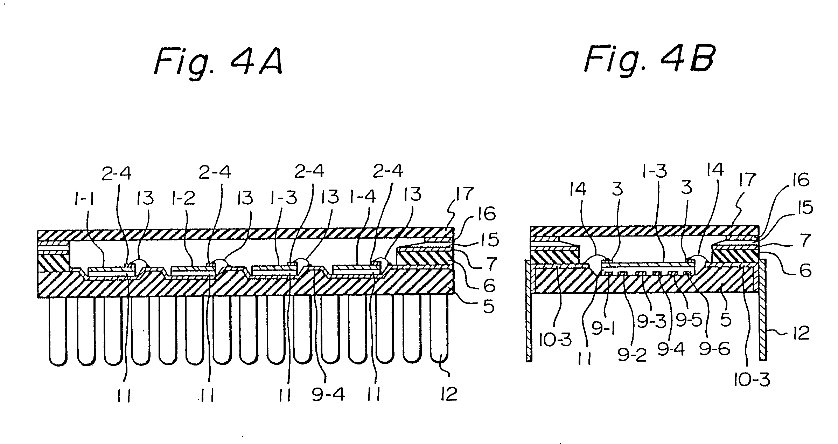

In Figs. 4A and 4B, which are similar to Figs. 3B and 3C, respectively, a sealing-completed semiconductor device is illustrated. Reference numeral 15 indicates solder material, 16 is a metallized layer for sealing, and 17 indicates a cap formed from a ceramic plate.

In the above-mentioned embodiment, chip bases 11 made of ceramic material are provided between the semiconductor chips 1—1 through 1—4 and the common conductive strips 9—1 through 9—6; however, such chip bases can be omitted when semiconductor chips having thick insulated layers on the back thereof or SOS chips are used.

As explained hereinbefore, the semiconductor device according to the present invention is advantageous in that the manufacturing cost is low since the semiconductor device, which has a chip-array construction, is formed by using a single conductive layer-constructed package which is manufactured at a low cost. Therefore, the present invention provides semiconductor devices of a high packing density at a low cost, thereby enabling a computer system to be small in size.

## Claims

1. A chip-array-constructed semiconductor device comprising a plurality of semiconductor chips (1—1 to 1—4) having circuit elements thereon and having connection pads, and a mounting (5) of a generally rectangular shape on which the plurality of semiconductor chips (1—1 to 1—4) are mounted, the mounting carrying a single conducting layer, the semiconductor chips (1—1 to 1—4) having their connection pads arranged around their periphery with the connection pads (2—1 to 2—6) that are common to all the chips (1—1 to 1—4) arranged in corresponding positions along two opposite sides on all the chips (1—1 to 1—4), and the single conducting layer being divided into common conducting strips (9—1 to 9—6) which are connected to the corresponding common connection pads (2—1 to 2—6), and into individual conducting strips (10—1 to 10—4) which are connected to the connection pads (3) that are individual to the individual chips (1—1 to 1—4), characterised in that the individual chips (1—1 to 1—4) have their individual connection pads (3) arranged along one or both ends of the chips, the common conducting strips (9—1 to 9—6) extend lengthwise along the mounting (5) under the chips (1—1 to 1—4) and the individual connecting strips (10—1 to 10—4) extend generally transverse to and at one or both sides of the common conducting strips (9—1 to 9—6) to external leads (12) located at the ends of the mounting (5).

2. A chip-array-constructed semiconductor device according to claim 1, mounted in a package (4) comprising a ceramic base (5), a ceramic frame (6) mounted on the ceramic base, and a ceramic cap (17) mounted on the ceramic frame to complete and seal the package (4).

3. A chip-array-constructed semiconductor device according to claim 2, in which the ceramic base (5) includes a plurality of recesses (8) for the semiconductor chips (1—1 to 1—4).

4. A chip-array-constructed semiconductor device according to claim 3, also including chip bases (11) for isolating the semiconductor chips (1—1 to 1—4) from the common conducting strips (9—1 to 9—6) in the recesses (8) in the ceramic base (5).

5. A chip-array-constructed semiconductor device according to any one of the preceding claims, in which the common conducting strips (9—1 to 9—6) are arranged in parallel to each other.

## Patentansprüche

1. Halbleitervorrichtung mit Chip-Array-Struktur, mit einer Vielzahl von Halbleiterchips (1—1 bis 1—4), die Schaltungselemente tragen und Verbindungspads haben, und einer Anordnung (5) von im allgemeinen rechtwinkliger Form, auf welcher die Vielzahl von Halbleiterchips (1—1 bis 1—4) montiert sind, wobei die Anordnung eine einzige leitende Schicht trägt, die Halbleiterchips (1—1 bis 1—4) ihre Verbindungspads um ihren Umfang angeordnet haben, wobei die Verbindungspads (2—1 bis 2—6), die allen Chips (1—1 bis 1—4) gemeinsam sind, in entsprechenden Positionen längs gegenüberliegenden Seiten auf allen Chips (1—1 bis 1—4) angeordnet sind, und die einzige leitende Schicht geteilt ist in gemeinsame leitende Streifen (9—1 bis 9—6), die mit den entsprechenden gemeinsamen Verbindungspads (2—1 bis 2—6) verbunden sind, und in einzelne leitende Streifen (10—1 bis 10—4), die mit den Verbindungspads (3) verbunden sind, die individuell zu den individuellen Chips (1—1 bis 1—4) gehören, dadurch gekennzeichnet, daß die individuellen Chips (1—1 bis 1—4) ihre individuellen Verbindungspads (3) längs einem oder beiden Enden der Chips angeordnet haben, die gemeinsamen leitenden Streifen (9—1 bis 9—6) sich längsweise längs der Anordnung (5) unter den Chips (1—1 bis 1—4) erstrecken und die individuellen Verbindungsstreifen (10—1 bis 10—4) sich im allgemeinen quer zu und an einer oder beiden Seiten der gemeinsamen leitende Streifen (9—1 bis 9—6) zu externen Leitungen (12), die an den Enden der Anordnung (5) angeordnet sind, erstrecken.

2. Halbleiteranordnung mit Chip-Array-Struktur nach Anspruch 1, welche in einer Packung (4) montiert ist, mit einer keramischen Basis (5), einem keramischen Rahmen (6), der auf der keramischen Basis montiert ist, und einer keramischen Kappe (17), die auf den keramischen Rahmen montiert ist, um die Packung (4) zu vervollständigen und zu versiegeln.

3. Halbleitervorrichtung mit Chip-Array-Struktur, nach Anspruch 2, bei der die Keramikbasis (5) eine Vielzahl von Ausnehmungen (8) für die Halbleiterchips (1—1 bis 1—4) umfaßt.

4. Halbleitervorrichtung mit Chip-Array-Struktur nach Anspruch 3, ferner einschließlich Chipbasen (11) zum Isolieren der Halbleiterchips (1—1 bis 1—4) von den gemeinsamen leitenden Streifen (9—1 bis 9—6) in den Ausnehmungen (8) in der keramischen Basis (5).

5. Halbleitervorrichtung mit Chip-Array-Struktur nach einem der vorhergehenden Ansprüche, bei der die gemeinsamen leitenden Streifen (9—1 bis 9—6) parallel zueinander angeordnet sind.

## Revendications

1. Dispositif semi-conducteur ayant la structure d'une série de puces, comprenant des puces ou pastilles à semi-conducteurs (1—1 à 1—4) portant des éléments de circuit sur elles et présentant des plots de sortie, ainsi qu'un support (5) de forme générale rectangulaire, sur lequel sont montées les pastilles (1—1 à 1—4), le support portant une couche conductrice unique, les plots de sortie des pastilles (1—1 à 1—4) étant disposés autour de la périphérie des pastilles, avec disposition des plots (2—1 à 2—6) qui sont communs à toutes les pastilles (1—1 à 1—4) à des positions correspondantes le long de deux côtés opposés sur toutes les pastilles (1—1 à 1—4), la couche conductrice unique étant partagée en bandes conductrices communes (9—1 à 9—6), lesquelles sont reliées aux plots de sortie communs (2—1 à 2—6) correspondants, et en bandes conductrices individuelles (10—1 à 10—4) reliées aux plots de sortie (3) qui sont particuliers aux différentes pastilles (1—1 à 1—4), caractérisé en ce que les plots de sortie particuliers (3) des différentes pastilles (1—1 à 1—4) sont disposés le long d'une ou des deux extrémités des pastilles, les bandes conductrices communes (9—1 à 9—6) s'étendent longitudinalement sur le support (5), sous les pastilles (1—1 à 1—4), et les bandes conductrices individuelles (10—1 à 10—4) s'étendent de manière générale transversalement aux bandes conductrices communes (9—1 à 9—6), d'un côté ou des deux côtés de celles-ci, jusqu'à des conducteurs extérieurs (12) situés sur les côtés du support (5).

2. Dispositif selon la revendication 1, monté dans un boîtier (4) comprenant un support céramique (5), un cadre céramique (6) monté sur ce support et un couvercle céramique (17) monté sur le cadre pour compléter et fermer le boîtier (4) de façon étanche.

3. Dispositif selon la revendication 2, dans lequel le support céramique (5) présente des creux (8) pour les pastilles à semi-conducteurs (1—1 à 1—4).

4. Dispositif selon la revendication 3, comprenant, en plus, des embases (11) de pastilles pour isoler les pastilles à semi-conducteurs (1—1 à 1—4) des bandes conductrices communes (9—1 à 9—6) dans les creux (8) du support céramique (5).

5. Dispositif selon l'une quelconque des revendications précédentes, dans lequel les bandes conductrices communes (9—1 à 9—6) sont disposées parallèlement entre elles.

# Fig. 1

Fig. 2A

Fig. 2C

Fig. 2B

Fig. 3C

Fig. 3A

Fig. 3B

0 067 677

## Fig. 4A

2-4  2-4  2-4  2-4

1-1  13  1-2  13  1-3  13  1-4  13  17

16

15

7

6

5

11  11  11  9-4  11  12

## Fig. 4B

1-3  14

14  3  3  17  16

15

7

6

12

10-3  9-1  9-3  9-5  5

11  9-2  9-4  9-6

10-3